# EUROPÄISCHE PATENTANMELDUNG

(11) **EP 2 749 850 A1**
(43) Veröffentlichungstag der Anmeldung: **02.07.2014**
(21) Anmeldenummer: 13196034.6
(22) Anmeldetag: 06.12.2013
(51) Int. Cl.: G01D 11/24, H03K 17/95

(54) **Induktiver Sensor**

(30) Priorität: 27.12.2012 DE 102012224386
(71) Anmelder: SICK AG, 79183 Waldkirch/Breisgau (DE)
(72) Erfinder: Machul, Olaf, 79249 Merzhausen (DE)
(74) Vertreter: Manitz, Finsterwald & Partner GbR

(57) **Zusammenfassung**

Ein induktiver Sensor umfasst ein fensterloses Ganzmetallgehäuse, welches als einstückiges Spritzgussbauteil ausgeführt ist und vollständig aus amorphem Metall gefertigt ist.

## Beschreibung

Die vorliegende Erfindung betrifft einen induktiven Sensor mit einem Ganzmetallgehäuse.

Derartige Sensoren werden auch als "induktive Ganzmetallsensoren" bezeichnet und finden zum Beispiel als Näherungsschalter Verwendung. Mittels des Gehäuses kann der Sensor am gewünschten Einbauort an einem jeweiligen Trägerbauteil befestigt werden, beispielsweise mit Hilfe eines an dem Gehäuse ausgebildeten Gewindes.

Üblicherweise weisen induktive Ganzmetallsensoren ein Gehäuse aus Edelstahl oder aus vernickeltem Messing auf. Bei der Herstellung gängiger Ganzmetallgehäuse sind häufig aufwändige und/oder toleranzbehaftete Arbeitsschritte wie Tiefziehen, Drehen oder Pulverspritzgießen (Metal Injection Molding, MIM) erforderlich. Ein weiteres Problem ist die vergleichsweise hohe elektrische Leitfähigkeit von Messing und Edelstahl. In einer elektrisch gut leitenden Gehäusewand werden nämlich durch den im Inneren des Gehäuses befindlichen Anregungs-Schwingkreis Wirbelströme erzeugt, was dem Messprinzip, Wirbelströme in einem äußeren bewegten Target zu erzeugen, entgegenwirkt. Dieser unerwünschte Effekt kann durch eine Verringerung der Wanddicke des Gehäuses abgemildert werden. Dies ist jedoch mit einer unerwünschten Verringerung der Stabilität des Sensors verbunden.

Um die vorstehend genannten Probleme zu mindern, könnte grundsätzlich vom Konzept des Ganzmetallsensors abgerückt werden, indem das Sensorgehäuse mit einem Fenster versehen wird, in welches ein Wandstück aus einem dielektrischen Material eingesetzt wird. Ein derartiges Fenster ermöglicht einen weitgehend verlustfreien Durchtritt der Anregungsschwingungen durch die Gehäusewand. Für viele Anwendungen scheiden jedoch induktive Sensoren mit solchen dielektrischen Gehäusefenstern aus, da sie z.B. nicht die erforderliche Beständigkeit gegenüber mechanischer Belastung, Temperaturschwankungen oder korrosiven Umgebungen aufweisen. Außerdem erfordert das Einsetzen eines Fensters in einen Gehäusekörper zusätzliche Arbeitsschritte, welche den Herstellungsprozess verteuern. Im Gegensatz zu Sensoren mit dielektrischen Fenstern ist ein fensterloser Ganzmetallsensor robuster und vielseitiger.

Das Ganzmetallgehäuse kann auch fensterlos ausgeführt sein und Bereiche aus amorphem Metall aufweisen. Amorphe Metallwerkstoffe, welche auch als "metallische Gläser" bezeichnet werden, weisen aufgrund ihrer nicht kristallinen Struktur im Vergleich zu Stahl eine relativ geringe elektrische Leitfähigkeit auf, sodass die gehäusebedingten Wirbelstromverluste beim Durchtritt der Anregungsschwingungen durch einen amorphen Bereich verringert sind.

Zum Beispiel umfasst ein solcher, amorphe Gehäusebereiche aufweisender Sensor einen in dem Gehäuse angeordneten Sender zum Erzeugen eines elektrischen Wirbelfeldes, wobei diejenigen Bereiche des Gehäuses, welche während des Betriebs des Senders dem elektrischen Wirbelfeld ausgesetzt sind, aus amorphem Metall gefertigt sind. Auf diese Weise ist sichergestellt, dass die Wirbelstromverluste beim Durchgang der Anregungsfelder durch das Gehäuse minimiert sind.

Insbesondere kann eine Frontplatte oder Frontkappe des Gehäuses aus amorphem Metall gefertigt sein. Der vordere Bereich des Gehäuses entspricht üblicherweise demjenigen Abschnitt, welcher den elektromagnetischen Anregungswellen in erster Linie ausgesetzt ist. Durch Ausbildung dieses Bereichs aus amorphem Metall können die gehäusebedingten Wirbelstromverluste auf ein Minimum begrenzt werden.

Die DE 10 2012 203 449 A1 offenbart einen induktiven Näherungsschalter, bei dem die Anregungsspule und der Spulenkern in eine Dichtmasse aus Glas eingebettet sind und bei dem die Frontplatte des Gehäuses aus amorphem Metall besteht.

In der DE 100 18 269 B4 ist ein magnetisches Positionsmessgerät mit einem an einem Bauteil anzubringenden magnetischen Maßstab und einem an dem Maßstab entlang zu bewegenden Tastkopf offenbart. Der Tastkopf weist einen Magnetfeld-Detektor auf, welcher in eine Vertiefung des Trägerkörpers eingelassen ist. Der Detektor ist durch eine dünne, unmagnetische Metallfolie abgedeckt, die aus einer amorphen Eisen-Nickel-Legierung bestehen kann.

Die EP 2 015 030 A2 offenbart ein Zeichentablett mit einer Empfangsspule, über die sich eine zweischichtige Abdeckplatte erstreckt. Eine Schicht der Abdeckplatte ist aus einem amorphen Metall gefertigt.

Es ist eine Aufgabe der Erfindung, die Herstellung von induktiven Ganzmetallsensoren zu vereinfachen und deren Empfindlichkeit zu erhöhen.

Die Lösung der Aufgabe erfolgt durch einen induktiven Sensor mit den Merkmalen des Anspruchs 1.

Erfindungsgemäß ist das Ganzmetallgehäuse vollständig aus amorphem Metall gefertigt. Dies ermöglicht eine besonders einfache Konstruktion.

Außerdem sind die Festigkeit und die Härte von amorphen Metallen im Vergleich zu kristallinen Metallen erhöht. Diese erhöhte Festigkeit ermöglicht es, das Gehäuse bei vorgegebener Stabilität dünnwandiger auszubilden. Je dünnwandiger das Gehäuse ist, umso geringer fallen die unerwünschten Wirbelstromverluste aus. Somit kann durch die Verwendung von amorphen Metallen als Material des Gehäuses die Empfindlichkeit eines induktiven Ganzmetallsensors beträchtlich gesteigert werden.

Ein weiterer Vorteil der Verwendung von amorphen Metallen bei der Herstellung von Sensorgehäusen besteht darin, dass amorphe Metalle vergleichsweise geringe Schrumpfraten aufweisen und daher werkzeuggebunden mittels spritzgussähnlicher Verfahren hergestellt werden können.

Demgemäß sieht die Erfindung vor, das Gehäuse aus amorphem Metall als Spritzgussbauteil auszuführen. Dies ermöglicht eine besonders einfache, schnelle und kostengünstige Herstellung. Bei Verwendung kristalliner Metalle wäre eine Herstellung mittels Spritzguss aufgrund der hohen Schrumpfraten im Allgemeinen ausgeschlossen.

Erfindungsgemäß ist das Gehäuse außerdem einstückig ausgebildet. Dadurch ist eine besonders einfache, robuste und stabile Ausführung gewährleistet.

Weiterbildungen der Erfindung sind in den abhängigen Ansprüchen, der Beschreibung sowie den beigefügten Zeichnungen angegeben.

Das amorphe Metall kann insbesondere eine amorphe Metalllegierung sein. Solche amorphen Metalllegierungen sind in unterschiedlichen Ausführungen erhältlich und im Vergleich zu alternativen kristallinen Metallen mit geringer Leitfähigkeit, wie Titan, relativ preisgünstig. Die Art der Legierung kann auf die jeweilige Anwendung zugeschnitten sein.

Vorzugsweise ist das amorphe Metall nicht magnetisch leitfähig.

Gemäß einer Ausführungsform der Erfindung weisen zumindest die aus dem amorphen Metall gefertigten Bereiche des Gehäuses eine Wandstärke von höchstens 0,5 mm, bevorzugt höchstens 0,3 mm und besonders bevorzugt höchstens 0,2 mm auf. Derart geringe Wandstärken sind mit kristallinen Metallen nicht in der erforderlichen Stabilität realisierbar. Die Empfindlichkeit des induktiven Sensors kann jedoch durch derart dünne Gehäusewände beträchtlich erhöht werden.

Die Erfindung wird nachfolgend beispielhaft unter Bezugnahme auf die Zeichnung beschrieben.
- Fig. 1: zeigt eine vereinfachte seitliche Schnittansicht eines nicht zur Erfindung gehörenden induktiven Sensors.
- Fig. 2: zeigt eine vereinfachte seitliche Schnittansicht eines induktiven Sensors gemäß einer Ausführungsform der Erfindung.

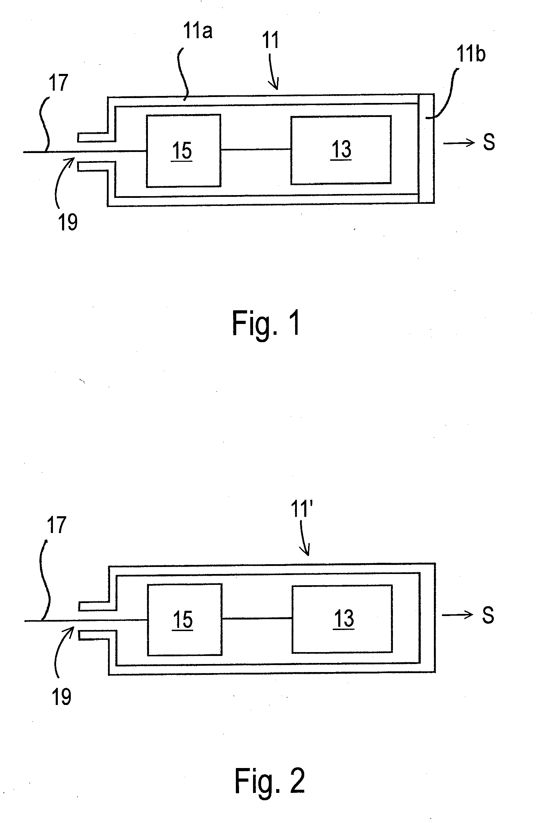

Fig. 1 zeigt einen nicht zur Erfindung gehörenden induktiven Näherungssensor, welcher ein Ganzmetallgehäuse 11 aufweist. Das Ganzmetallgehäuse 11 umfasst einen im Wesentlichen hohlzylindrischen Basisabschnitt 11a, der an einem vorderen Ende durch eine Frontplatte 11b verschlossen ist. Im Inneren des Ganzmetallgehäuses 11 ist ein an sich bekannter Sender 13 zum Erzeugen von elektromagnetischen Anregungsschwingungen sowie eine mit dem Sender 13 in Verbindung stehende elektronische Auswertungseinheit 15 untergebracht. Die elektronische Auswertungseinheit 15 gibt über eine Signalleitung 17 ein Sensorsignal aus, welches die Position eines nicht dargestellten Targets angibt. Die Signalleitung 17 ist durch eine Durchführung 19, welche an einem hinteren Ende des Ganzmetallgehäuses 11 vorgesehen ist, nach außen geführt.

Bei dem in Fig. 1 dargestellten Sensor ist der hohlzylindrische Basisabschnitt 11a aus Edelstahl gefertigt, während die Frontplatte 11b aus einer amorphen Metalllegierung gefertigt ist. Es können insbesondere amorphe Metalllegierungen auf Grundlage von Zirkonium und Titan zur Anwendung kommen. Die Hauptabstrahlrichtung S des Senders 13 weist in Richtung der Frontplatte 11b, so dass die Anregungsfelder lediglich durch eine Gehäusewand aus amorphem Metall hindurchtreten. Dadurch werden Wirbelstromverluste im Ganzmetallgehäuse 11 weitgehend vermieden. Zudem kann aufgrund der großen Härte und Festigkeit des amorphen Metallwerkstoffs die Frontplatte 11b relativ dünn, beispielsweise in einer Wandstärke von 0,2 mm, ausgeführt werden, wodurch die Wirbelstromverluste weiter verringert werden. Der induktive Sensor weist somit eine beträchtlich höhere Empfindlichkeit auf, als dies unter Verwendung eines vollständig aus Edelstahl oder Messing gefertigten Gehäuses möglich wäre.

In Fig. 2 ist ein erfindungsgemäßer induktiver Sensor dargestellt, wobei hier das Ganzmetallgehäuse 11' vollständig aus einer amorphen Metalllegierung gefertigt ist. Ein besonderer Vorteil besteht hierbei darin, dass die Herstellung werkzeuggebunden mittels eines spritzgussähnlichen Verfahrens und somit besonders einfach und kostengünstig erfolgen kann. Die Herstellung in einem spritzgussähnlichen Verfahren erlaubt zudem eine größere Gestaltungsfreiheit.

Grundsätzlich können auch andere Typen von induktiven Sensoren wie induktive Magnetfeldsensoren, Füllstandssensoren oder dergleichen mit einem Ganzmetallgehäuse aus amorphem Metall versehen werden.

### Bezugszeichenliste

- 11, 11': Ganzmetallgehäuse
- 11a: Basisabschnitt
- 11b: Frontplatte
- 13: Sender
- 15: elektronische Auswertungseinheit
- 17: Signalleitung
- 19: Durchführung

- S: Hauptabstrahlrichtung

## Patentansprüche

1. Induktiver Sensor mit einem fensterlosen Ganzmetallgehäuse,
**dadurch gekennzeichnet, dass**
das Ganzmetallgehäuse (11') als einstückiges Spritzgussbauteil ausgeführt und vollständig aus amorphem Metall gefertigt ist.

2. Sensor nach Anspruch 1,
**dadurch gekennzeichnet, dass**
das amorphe Metall eine amorphe Metalllegierung ist.

3. Sensor nach zumindest einem der vorstehenden Ansprüche,
**dadurch gekennzeichnet, dass**
das amorphe Metall nicht magnetisch leitfähig ist.

4. Sensor nach zumindest einem der vorstehenden Ansprüche,
**dadurch gekennzeichnet, dass**
zumindest die aus dem amorphen Metall gefertigten Bereiche des Ganzmetallgehäuses (11') eine Wandstärke von höchstens 0,5 mm, bevorzugt höchstens 0,3 mm, und besonders bevorzugt höchstens 0,2 mm aufweisen.
